# EUROPEAN PATENT APPLICATION

(11) **EP 3 035 382 A1**
(43) Date of publication of application: **22.06.2016**
(21) Application number: 15198089.3
(22) Date of filing: 04.12.2015
(51) Int. Cl.: H01L 23/15, H01L 23/552, H01L 23/66

(54) **SHIELDED RF TRANSMISSION LINES IN LOW TEMPERATURE CO-FIRED CERAMIC CONSTRUCTS AND METHOD OF MAKING SAME**

(30) Priority: 15.12.2014 US 201462091713 P
(71) Applicant: University Of Windsor, Windsor, Ontario N9B 3P4 (CA)
(72) Inventor: CHOWDHURY, Sazzadur, Windsor, Ontario N8B 3A4 (CA)
(74) Representative: Lampis, Marco

(57) **Abstract**

An integrated circuit assembly which includes stacked printed ceramic substrate layers, and incorporates a shielding enclosure extending about the electrical conductor traces and interconnects which form the assembly circuitry. The shielding enclosure is configured to reduce electric and/or magnetic field leakage or interference with the traces and interconnects. The enclosure is provided as a cage about the assembly circuitry, and which is formed as arrays of ground conductors in electrical communication with ground plates.

## Description

### RELATED APPLICATIONS

This application claims priority and the benefit of 35 USC §119(e) to United States Provisional Patent Application Serial No. 62/091713, filed 15 December 2014, the disclosure of which is incorporated herein by reference in its entirety.

### BACKGROUND OF THE INVENTION

Low temperature co-fired ceramic (LTCC) sheets or substrates and tapes such as GreenTape™ sold by DuPont, have proven useful in the manufacture of multilayer integrated circuits, circuit laminates, chip packages, RF modules, wiring boards and other such electronic constructs (hereinafter generally referred to as an integrated circuit "construct or assembly"). Typically LTCC substrates are formed from glass (CaO-Al₂O₃-SiO₂-B₂O₃) and alumina (Al₂O₃) compositions. The LTCC tapes function as a dielectric substrate onto or through which gold, silver or other suitable conductor strips may be printed using film screen printing methods in conjunction with metal deposition and etching technologies, to form internal circuit conductors. After printing, the tape layers are collated, stacked and brazed, sintered or laminated to fuse the layers. The fused layers provide a formed multilayer construct having a desired and readily customizable conductive circuitry.

While the use of LTCC tapes shows promise to the simplified customization and manufacture of multilayer circuit constructs, heretofore electric and/or magnetic field leakage and interference across the printed conductor strips has proven a limitation in the miniaturization of the printed circuitry.

### SUMMARY OF THE INVENTION

The present invention seeks to provide an integrated circuit construct or assembly which allows for the stacked assembly of printed ceramic substrate or tape layers. More particularly, the assembly incorporates a shielding enclosure extending about at least part of the electrical conductor traces and/or interconnects which form the assembly circuitry or electrical conductor framework. The shielding enclosure is configured to reduce or minimize electric and/or magnetic field leakage or interference with or from printed conductive traces and/or transverse conductor interconnects which extend as part of the conductor framework within the assembly interior.

More preferably, the shielding enclosure is provided with a series of ground conductors which electrically communicate with ground leads, wires or plates (hereinafter collectively ground plates). The ground conductors are preferably formed by in-filling vias formed transversely through one or more of the ceramic substrates or layers with a suitable conductive metal, such as gold, silver, or the like. The ground conductors may be provided in one or more arrays arranged along side portions of conductive traces and/or radially about transverse interconnects. Most preferably, the ground conductors are provided in a generally cage-like orientation about the electrical traces and/or interconnects.

In one preferred embodiment, the present invention provides a LTCC construct or assembly, and more preferably a shielded RF conductor, which is formed as a construct of bonded stacked low temperature co-fired ceramic (LTCC) tape layers in which strip or trace conductors are substantially encapsulated and/or surrounded by a common electrically conductive shielding enclosure. Preferably, the shielding enclosure has the same impedance as a common ground layer.

More preferably, the shielding enclosure includes a ground assembly having one or more ground layers provided in the form of conductive metal sheets. Preferably the ground layers comprise gold, silver or copper layers which are printed on one or more spaced tape layers at layer positions above and/or below conductor traces and/or interconnects which are shielded. More preferably, the ground plates or sheets extend beyond the shadow area of the electrical conductor framework, thus providing the top and bottom shielding. The side and edge shielding is preferably also provided by way of a series of closely spaced in-filled vias that from the ground conductors and electrically connect the top and bottom sheets, much like a series of bars in a cage.

For vertical shielded transverse electrical conductors or interconnects, a hole is formed into the horizontal shielding plate layer itself which is large enough to allow a conductor via to pass through the ground plate without having electrical contact therewith. The conductor via is then formed through the LTCC tape surrounded by an array of closely spaced ground vias which extend through the shielding plate and tape. The ground vias in the array are most preferably provided in a radially spaced orientation about the transverse conductor via. The ground vias are electrically connected to the ground plate. The peripherally extending ring of ground vias preferably run parallel around the conductor via concentrically thereabout. The vias are in-filled with a suitable conductive metal to form the electrical conductor or interconnect, as well as an array of continuous shielding ground conductors and/or other termination points for further conducting vias.

In one possible construction, the LTCC layers are provided with one or more trace conductor strips and/or in-filled electrical conductor vias or interconnects that extend longitudinally along the tape layer surfaces, or which span transversely one or more tape layer thicknesses. The trace strips are printed and vias are in-filled with a conductive material or metal such as gold or silver, to provide the stacked construct with the desired conductive circuitry or electrical conductor framework, and preferably a conductive microstrip or stripline.

The common shielding enclosure surrounding the conductive microstrip or stripline is provided in the form of a ground cage which consists of spaced in-filled grounded vias which electrically interconnect with top and bottom ground plates. Optionally one or more intermediate ground plates may be formed relative to the stacking direction of the LTCC layers, so as to extend at least partially between interposed tape layers, particularly when the conductors change levels vertically or when the conductors change direction horizontally. The shielding enclosure preferably is provided with a series of surrounding ground conductors formed as in-filled ground vias. The ground conductors may be arranged in an array extending along each longitudinal side of the conductive trace strips through both the underlying and overlying adjacent LTCC layers. Where a transversely extending interconnect is provided to join two or more vertically spaced electric trace spaced in-filled ground vias or ground conductors project vertically through the LTCC layers in an arrangement spaced radially about the interconnect to electrically connect with underlying and overlying ground plates, and form a shielded radio frequency (RF) corridor or transmission line.

As will be described in one non-limiting method of manufacture, a low temperature co-fired ceramic integrated circuit construct is provided, and which is formed having the desired three dimensional microstructure architecture. Preferably, a series of co-fired ceramic circuit material layers or tapes, such as GreenTape™ manufactured by DuPont, is used to form the construct. Depending on the desired interconnect features, each LTCC layer is printed with the desired associated conductive trace, and/or selected conductor via interconnects are formed through the tape layers by a suitable through-blanking process. The traces and conductor vias are arranged so that when the tape layers are stacked and fused, the resulting trace/via pathway provides the desired multilayer interconnect features, having regard to the desired final stacked layer construction.

A series of spaced ground vias are formed through each LTCC tape layer adjacent each associated conductor trace and conductor interconnect. The ground vias are arranged to form a longitudinal cage extending longitudinally along each longitudinal side of the conductor trace. The ground vias are preferably spaced in an array of columnarly aligned rows a distance of between about 80 and 250 microns, and more preferable 100 to 150 ± 25 microns from the conductor strip and/or each other. Although not essential, preferably the ground vias are arranged in a generally equally spaced orientation on each longitudinal side of the electric traces. Second arrays of ground vias, each generally corresponding in size and position to an associated ground via of the first arrays, is formed through the next adjacent tape layer. The second array of ground vias are positioned to align with an associated ground via of the first array. In this manner, in final stacking and assembly, the ground vias of the second array generally overlie and communicate with an associated lower ground via.

In addition to the columnarly aligned rows of ground vias, concentrically arranged arrays of ground vias are formed through each LTCC tape layer about each transverse conductor via. In particular, where the tape is provided with a conductor via used to form an interconnect to electrically join conductor traces to, the ground vias preferably extend through the tape layer arranged as an array extending along an arcuate path generally concentrically about a trace strip end, and more preferably which is also concentric about the conductor via. Where conductor vias extend vertically through the tape layer for electrical communication with vertically adjacent conductor vias, the ground vias may be arranged in a generally circular array at equally spaced locations located concentrically about the conductor via.

Ground plates are printed on spaced tape layers to electrically interconnect each of the ground vias. In one possible design, ground plates may also be printed between tape layers and provided with key-hole apertures, positioned such that the ground plate material extend peripherally about any conductor trace and or interconnects.

After the vias are formed, conductive metallization pastes are screen printed layer-by-layer to concurrently print the desired conductor layers, ground plates and to in-fill both ground and conductor vias with conductive metal such as gold, silver or other suitable material. Optionally, selected tape layers may be formed as inner layers in the final construct and have radio frequency (RF) transmission lines printed as conductor traces in corridor areas defined between rows of ground vias and which preferably runs in substantially the same longitudinal direction as corridor areas defined thereby.

Most preferably, the tape layer is used to form the uppermost layer of the circuit construct preferably has a ground plate conductors printed on both the top and bottom outside faces. By such printing, the ground conductor connects each of the ground vias that span the height of the construct.

The layers are stacked and collated so that the interconnect forms as in-filled conductive vias and trace strips are provided in the desired electrical communication. In addition, the in-filled ground vias extending through the selected layers electrically communicate either directly or indirectly with one or more in-filled ground vias in over or underlying layers to form ground conductors which electrically communication with the ground plates. As a result of this stacking, the cage of ground conductors and ground plates is formed about both horizontal conductive trace runs, with ground conductors bordering each longitudinal side thereof, and with vertical electrical conductor or interconnect run areas partially or completely electronically connected vertical ground conductor cages.

After stacking, the layers are laminated and fired or sintered at low temperatures, preferably at temperatures below 1300°C, and more preferably below 900°C. Optionally, the stacked construct may be subjected to post-processing and RF-characterization if necessary.

The present invention advantageously provides an arrangement of ground vias as a shielding boundary around in-filled conductive vias or interconnects and traces. The shielding assembly or cage thus forms a shield which assists in confining electric and/or magnetic fields, preventing or reducing signal loss as well as outside magnetic fields and signals from causing interference to signals travelling along chip circuitry and RF transmission lines.

Accordingly, as described herein, the present invention resides in a number of non-limiting aspects, and which include without restriction:
1. An integrated circuit assembly comprising: a low temperature co-fired ceramic (LTCC) layer, said LTCC layer having a transverse thickness and opposed top and bottom surfaces; an electrical conductor comprising: at least one electrical interconnect or transverse conductor member extending transversely through said LTCC layer; shielding enclosure comprising a ground plate assembly and an array of ground conductor members, each of said ground conductor members extending transversely through said LTCC layer from a respective first conductor end to a second conductor end, the ground conductor members of said array being disposed in an orientation spaced from and extending about at least part of a periphery of said electrical conductor or interconnect member, wherein the first and second conductor ends of the ground conductor members each electrically communicate with the ground plate assembly, and the spacing of the ground conductors members in the conductor array is selected to reduce at least one of electric and/or magnetic field interference with or from the electrical conductor or interconnect member.
2. A shielded RF conductor assembly comprising: a pair of stacked lower temperature co-fired ceramic (LTCC) layers, each said LTCC layers having a thickness in a transverse direction and generally parallel, planar associated top and bottom surfaces; an electrical conductor comprising an electrical trace conductor extending longitudinally along at least part of said associated said top or bottom surface of a juxtaposed pair of said LTCC layers; a shielding enclosure comprising a plurality of ground conductor members each in electrical communication with a ground, at least some of said ground conductors extending transversely through said stacked pair of LTCC layers and being disposed in a conductor array spaced from and oriented about longitudinal side portions of at least part of said electrical trace conductor; and the ground conductor members in the conductor array being spaced from each other and/or said part of electric trace conductor by a distance selected to reduce interference with or from the part of the electrical trace conductor.
3. An integrated circuit assembly comprising: first and second low temperature co-fired ceramic (LTCC) substrate layer, each said LTCC layer having respectively spaced top and bottom surfaces; said first and second LTCC layers being provided in a substantially stacked orientation with the bottom surface of the first LTCC layer in substantially juxtaposed contact with the top surface of the second LTCC layer; an internal conductor framework comprising: an electrical conductor member or interconnect extending transversely through said first LTCC layers, and an electrical trace conductor electrically communicating with said electrical conductor member or interconnect and extending longitudinally along at least part of the first LTCC layer bottom surface and the second LTCC layer top surface, a shielding enclosure comprising a ground plate assembly; a plurality of ground conductor members, a first grouping of said ground conductor members extending transversely through said first LTCC layer in a first conductor array in an orientation spaced from and extending radially about a peripheral portion of said electrical conductor member or interconnect; a second grouping of said ground conductor members extending transversely through each of said first and second LTCC layers, the ground conductor members of said second grouping being oriented along longitudinally opposed side portions of said electrical trace conductor; wherein each of the ground conductor members electrically communicating with the ground plate assembly; and wherein the spacing of the ground conductors members in the shielding enclosure is selected to reduce at least one of electric and/or magnetic field interference with or from at least part of the internal conductor.
4. An assembly in accordance with any of the other aspects described herein, which further includes at least one transverse electrical conductor member electrically communicating with the electrical trace conductor, the transverse electrical conductor member extending transversely through at least one of said pair of LTCC layers, said shielding enclosure including a further array of ground conductors, the ground conductors in said further array extending transversely through said at least one of said pair of LTCC layers in a partially radial spaced orientation about the electrical conductor member.
5. An assembly in accordance with any of the other aspects described herein, wherein the ground conductor members in said conductor assembly are spaced from said electrical trace conductor by a distance selected at between about 80 and 250 microns, and preferably 150 to 200 microns; and/or where the via diameter is selected at 100 microns to 400 microns; and/or wherein the via pitch is selected at about 2.5 x via diameter.
6. An assembly in accordance with any of the other aspects described herein, wherein the ground conductor members in said further conductor array are provided in a generally equispaced orientation concentrically about the electrical conductor member.
7. An assembly in accordance with any of the other aspects described herein, wherein said stacked LTCC layers comprise fused LTCC tape layers having a thickness selected at between about 0.1 mm and 0.9 mm, and said electric conductor comprise a conductive metal selected from the group consisting of gold, silver, copper and their alloys.
8. An assembly in accordance with any of the aspects described herein comprising a further low temperature co-fired ceramic (LTCC) layer, a bottom surface of said further LTCC layer being positioned substantially in juxtaposition with a top surface of said LTCC layer, said electrical conductor further comprising: an electric conductor trace extending longitudinally along said top surface, said electric conductor trace electrically communicating with said electrical conductor member; and said shielding enclosure further including a further array of ground conductor members extending transversely through each of the LTCC layers, the ground conductor members of the further array being disposed along longitudinally opposed side portions of said electric conductor trace.
9. An assembly in accordance with any of the other aspects described herein, wherein the electrical conductor or interconnect member and/or each of the ground conductor members have a diameter selected at between about 100 and 400 microns, and preferably about 175 and 200 microns.
10. An assembly in accordance with any of the other aspect described herein, wherein the ground conductor members are spaced from said electrical conductor by a distance selected at between about 80 and 250 microns, preferably 150 and 200 microns.
11. An assembly in accordance with any of the other aspects described herein, which includes a plurality of said LTCC layers, wherein said LTCC layers are fused to each other in a stacked juxtaposed orientation.
12. An assembly in accordance with any of the other aspects described herein, wherein said LTCC layer comprises one of a stacked pair of LTCC tape layers having juxtaposed surfaces, said LTCC tape layers each having a thickness selected at between about 0.1 mm and 0.9 mm and preferably between about 0.1 and 0.3 mm; the electrical conductor comprises a metal conductor and further includes metal trace conductor member extending longitudinally along at least one of said juxtaposed LTCC tape layer surfaces, the shielding enclosure including a further array of ground conductor members extending transversely through both of said stacked LTCC tape layers, the ground conductor members of said further array being spaced from and oriented along longitudinal side portions of said metal trace conductor member.
13. An assembly in accordance with any of the other aspects described herein, wherein the electrical conductor or interconnect member is provided in electrical communication with the electrical trace conductor.
14. An assembly in accordance with any of the other aspects described herein, wherein the ground plate assembly comprises at least one ground plate extending along at least part of said LTCC layer.
15. An assembly in accordance with any of the other aspects described herein, wherein said electrical conductor or interconnect member and said ground conductor member comprise conductive metal in-filled vias.
16. An assembly in accordance with any of the other aspects described herein, wherein the electrical conductor member and/or each of the ground conductor members in the conductor array have a diameter selected at between about 100 and 400 microns, preferably about 200.
17. An assembly in accordance with any of the other aspects described herein, wherein the ground plate assembly includes a top ground plate extending along at least part of the top surface of the first LTCC layer.
18. An assembly in accordance with any of the other aspects described herein, wherein the ground plate assembly includes a bottom ground plate extending along at least part of the bottom surface of the second LTCC layer.
19. An assembly in accordance with any of the other aspects described herein, wherein said stacked LTCC layers comprise fused LTCC tape layers having a thickness selected at between about 0.1 mm and 0.9 mm, and said electric conductor comprise a conductive metal selected from the group consisting of gold, silver, copper and their alloys.
20. A method of forming the assembly in accordance with any of the other aspects described herein comprising: printing an electrical trace on said part of a low temperature co-fired ceramic (LTCC) substrate to form said electrical trace conductor; forming a first via array through said first LTCC substrate the vias of said first via array being spaced along longitudinally opposing side portions of said electric trace; forming a secondary array of via holes through a second low temperature co-fired ceramic (LTCC) substrate, the second array being characterized by a hole spacing and orientation corresponding to a hole spacing and orientation of the first via array; bonding said second LTCC substrate in juxtaposition with said first LTCC substrate and with the first via array aligned with the second via array; electro depositing in each of said aligned vias conductive metal to form an associated one of said ground conductors therein.
21. The method of forming the assembly in accordance with any of the other aspects or methods described herewith, wherein the first via array is characterized by a preselected hole spacing and orientation relative to the portion of the electrical trace conductor which is selected to provide said ground conductors with a spacing selected to minimize electric and/or magnetic field interference therefrom.

### BRIEF DESCRIPTION OF THE DRAWINGS

Reference may be had to the following detailed description taken together with the accompanying drawings in which:
Figure 1 shows a partial cross-sectional view of an RF conductor assembly formed with stacked LTCC ceramic tape layers, in accordance with a preferred embodiment of the invention;
Figure 2 illustrates a partially cut away perspective view of the conductor trace and the ground shielding cage used in the RF conductor assembly of Figure 1;
Figure 3 shows a partial perspective view of the ground shielding cage used in the RF conductor of Figure 1;
Figure 4 shows an enlarged partial perspective view of the positioning of shielding cage conductors relative to an upper ground conductor plate and transverse electrical in the RF conductor assembly of Figure 1;
Figure 5 shows an enlarged partial perspective view showing the positioning of the shielding cage conductors relative to a lower ground conductor plate and transverse electrical conductor in the RF conductor assembly of Figure 1; and
Figure 6 illustrates schematically the process steps of assembling the RF conductor assembly of Figure 1 in accordance with a preferred method of manufacture.

### DETAILED DESCRIPTION OF THE PREFERRED EMBODIMENT

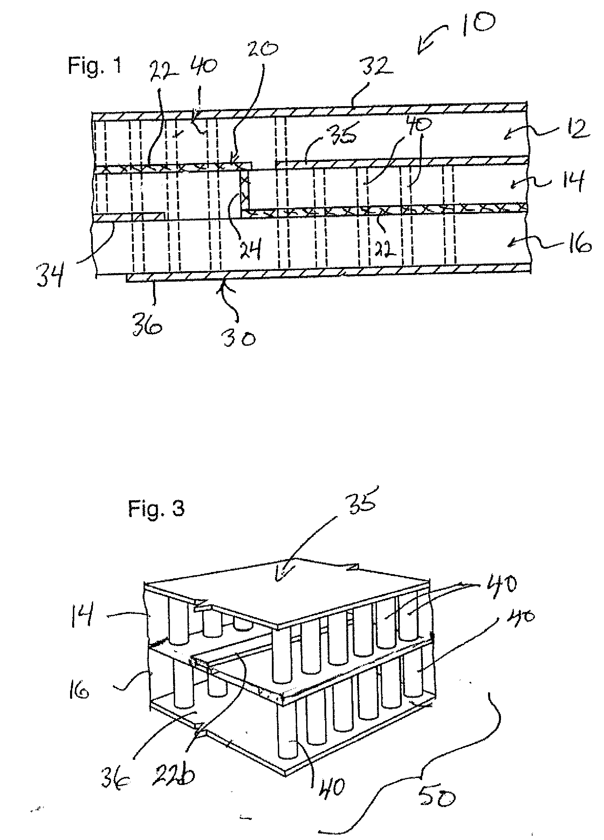

Reference may be had to Figure 1 which illustrates an integrated circuit construct in the form of a shielded LTCC RF conductor assembly 10 in accordance with a preferred embodiment of the invention. For simplicity the RF conductor assembly 10 is shown formed as a three-layer construct. The conductor assembly 10 includes three stacked LTCC tape layers 12,14,16, and is provided internally with an electrical conductor framework 20 which provides the desired assembly circuitry, and a grounded shielding enclosure or cage 30. As will be described, the shielding case 30 is provided in an orientation and with a spacing about the conductor framework 20 to minimize and/or reduce electrical and/or magnetic interference therewith. It is to be appreciated that while the assembly 10 is shown with three LTCC layers 12,14,16, the assembly 10 could be formed having fewer or greater number of tape layers, depending upon the final desired circuitry to be achieved.

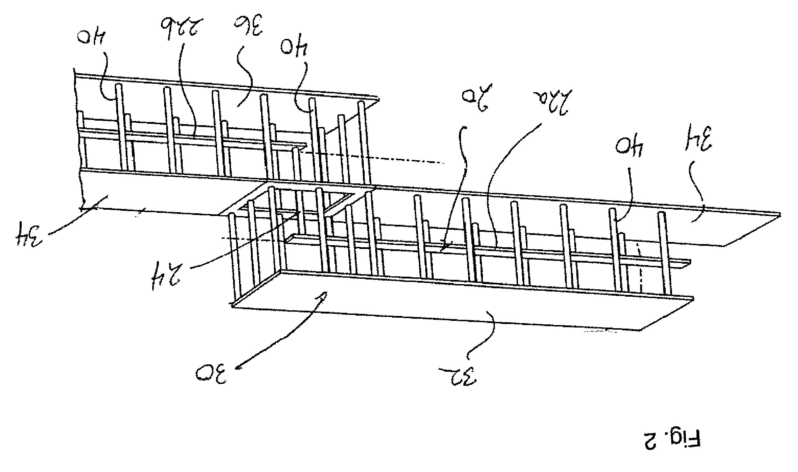

Figure 2 shows in isolation the conductor framework 20 as well as shielding cage 30 used in the assembly 10 of Figure 1. The conductor framework 20 includes both horizontally extending interconnect or electrical strip or traces 22, as well as transversely extending electrical conductors 24 which interconnect with vertically spaced traces 22a,22b. The conductor framework 20 provides the RF conductor assembly 10 with the desired circuitry, with horizontally extending strips or traces 22, being formed on an upper surface of tape layers 14,16, respectively by photo-printing. As will be described, the electrical conductors 24 used to interconnect the traces 22 are formed as conductive metal in-filled conductor vias 24. In this manner, the transversely extending electrical conductors 24 extend vertically and in electrical communication with the end of an upper trace conductor strip 22a on the top surface of tape layer 14, to electrically connect with the end of a lower position trace conductor strip 22b, formed on the top surface of tape layer 16.

Figure 2 shows best the shielding cage 30 used in the RF conductor assembly 10. The shielding cage 30 is formed so as to extend substantially about the conductor framework 20 to reduce or prevent electric and/or magnetic field leakage therewith.

In the embodiment shown in Figures 1 and 2, the shielding cage 30 includes a series of conductive metal ground plates 32,34,35,36 which are electrically interconnected by a series of transversely extending ground conductors 40. Each of the ground plates 32,34,35,36 are in turn in electrical communication with a suitable ground. Most preferably, the top most and bottom most ground plates 32,36 are formed by printing conductive metal layer on the respective opposing top or bottom surfaces of the top and bottom tape layers 12,16. Although not essential, in a simplified construction the top and bottom most ground plates 32,36 may extend so as to substantially form the top and bottom surfaces of the assembly 10.

Figure 2 shows best the ground plates 32,34,35,36 as being generally oriented in spaced opposed pairs aligned with the horizontally extending electric traces 22a,22b. The opening pairing of ground plates 32,34,35,36 are further electrically connected with a respective array grouping of ground conductors 40. As shown schematically in Figure 2, the ground conductors 40 extend transversely through one or more of the tape layers 12,14,16 so as to connect at their ends with the ground plates 32,34,35,36 to form a cage-like enclosure which extends about both horizontal traces 22, as well as the transverse electric conductors 24.

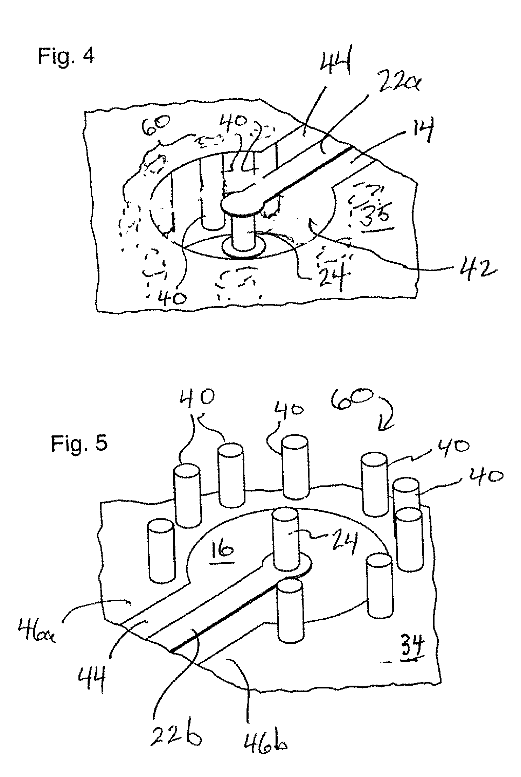

The ground conductors 40 are preferably provided in groupings arranged longitudinal array configuration 50 shown in Figure 3, or a radial array configuration 60 shown in Figures 4 and 5, depending on their position relative to the conductive trace 22 and transverse electrical conductors 24 of the conductor framework 20. In the first orientation 50 shown best in Figure 3 the ground conductors 40 are arranged as a generally equally spaced longitudinally extending columnar array along longitudinal side portions of each conductor trace (trace 22b shown for clarity).

As shown in Figure 1 the ground conductors 40 which extend about the upper conductor trace 22a are preferably arranged in an orientation extending through layers 12,14 in general alignment with the longitudinal extent of the trace 22a, and electrical communication with the ground plate 32 and either underlying ground plates 34 and/or 36. Likewise, the ground conductors 40 which extend longitudinally along each side of the lower trace 22b extend vertically through layers 14,16 and electrically communicate ground plate 36, as well as either overlying ground plate 32 and/or 35.

Figures 4 and 5 illustrate the ground conductor 40 positioning in the second array 60 about the transverse electrical conductor 24. In Figure 4 the ground conductors 40 are oriented in the array 60 extend in an equally spaced arrangement concentrically along an arc about the transverse electrical conductor 24. The ground conductors 40 of the array 60 are shown in electrical communication with both over and underlying ground plates 35,36, as well as optionally the top ground plate 32, depending on the vertical extend of the interconnect.

Although not essential, the intermediate ground plates 34,35 preferably define an open internal key-way passage (Figure 4) 42, formed with a slotted end 44. As shown by in Figure 5, the ends 44 expose the LTCC taper layers 14,16 and to define opposed ground strips 46a,46b which extend horizontally along each side of the trace conductor strip 22b.

While not shown for clarity, it is to be appreciated that additional ground members 40 are further provided as longitudinally extending arrays 50 along each longitudinal side of the conductor strip 22a in a similar manner as shown in Figure 3.

It is to be appreciated that as the shielding cage 30 is preferably formed so as to extend along each side and above and below each conductor trace 22 and electrical conductors 24. As a result, the conductor framework 20 is substantially shielded by a grounded conductive enclosure, minimizing electric and magnetic field interference therewith.

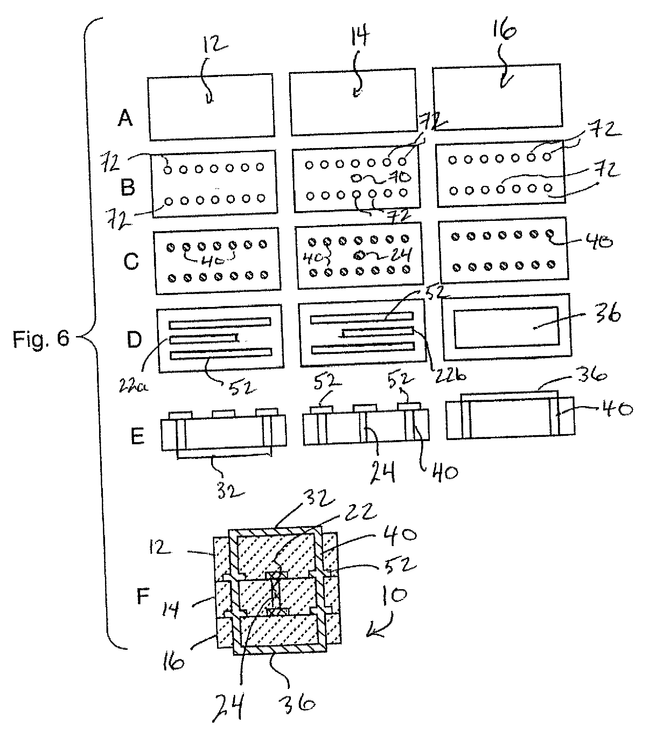

A preferred mode of manufacture shown best with reference to Figure 6 in which like reference number are used to identify like components. In an initial step (A) unfired ceramic substrate layers or tapes 12,14,16 which are formed through known processes, are individually blanked to form a number of both empty electrical conductor vias 70, as well as ground vias 72. The vias 70,72 are chosen with a size and spacing which is to be infilled to form respectively the electrical conductor 24 and ground conductors 40 that extend transversely at desired locations through the selected tape layers 12,14,16. The empty vias 70,72 are arranged such that when the layers 12,14,16 are collated and stacked, the vias 70,72 will align and whereby metal infilled therein will form the desired in-filled electrical conductor 24 and ground conductor 40 orientation and provide the desired degree of electrical connectivity.

Each of the conductor and ground vias 70,72 is provided with a diameter of between about 100 and 400 microns, and preferably about 200 microns, to form transverse electrical conductors 24 and ground conductors 40 of a corresponding size. The spacing of the in-filled ground vias 72 from the conductor trace 22, transverse conductor 24 and each other in-filled ground via is typically chosen at between about 80 and 200 microns, preferably 125 and 150 microns. The final spacing, size and number of the in-filled ground vias will, however, be chosen relative to the conductive stripline dimensions to reduce or prevent leakage of electric and magnetic fields and interference signals within the corridor.

After the empty vias 70,72 are formed, in next step (B) metallization pastes are screen printed layer-by-layer, to in-fill the vias 70,72 in each tape layer 12,14,16 with gold or another suitable conductive material (step (D)). In addition, the desired conductor traces 22 having typical widths selected at between about 80 and 125 microns, and the grounding plates (plates 32,36 shown for clarity) are formed on the tape surfaces 32,34,36 by printing or the like (step (E)).

In a simplified construction, the topmost tape layer 12 has a grounding plate 32 printed on its top outside face, and which, by its printing, connects the in-filled ground via 72 used to form the ground connectors 40. The bottommost tape layer 16 conductor assembly 10 construction has the grounding plate 36 printed over its entire bottom outside face, to connect the lower ends of the in-filled ground via 72. Optionally, for enhanced interconnectivity the intermediate and lower tape layers 14,16 may be photoprinted to form ground strips 52 which electrically connect the exposed end of the in-filled ground vias 72, as shown in Figure 6 steps (D) and (E).

The printed LTCC layers 12,14,16 are then collated and stacked (step(F)), so that the in-filled conductor vias 70, ground vias 72 and trace strips 22, are in the desired orientation and are provided with the desired interconnections. Following stacking and collation the layers 12,14,16 are sintered to fuse the stacked assembly. Finally, the sintered stack undergoes post-processing and final RF characterization. As a result of the surrounding conductive shielding cage 30, the shielded RF conductor framework 20 permits carriage of weaker signals, and the transmission of signals through interference-heavy environments along and across the LTCC layers 12,14,16, while preventing or reducing distortion or loss.

As a result of stacking, the ground shielding cage 30 forms stacked corridor areas, the top and bottom, along each longitudinal side and interconnect of the conductor framework 20.

While the detailed description describes the preferred embodiment as residing in an RF conductor assembly 10, the invention is not so limited. It is to be appreciated that the ground shielding cage 26 of the present invention may be provided as part of a variety of differing types of LTCC stacked constructs and integrated circuit assemblies, without departing from the scope of the invention.

## Claims

1. An integrated circuit assembly (10) comprising:
a low temperature co-fired ceramic (LTCC) layer (12, 14, 16), said LTCC layer having a transverse thickness and opposed top and bottom surfaces;
an electrical conductor (20) comprising:
at least one electrical interconnect member (24) extending transversely through said LTCC layer (12, 14, 16);
the assembly further **characterized by** a shielding enclosure (30) comprising a ground plate assembly (32, 34, 35, 36) and an array (50, 60) of ground conductor members (40), each of said ground conductor members (40) extending transversely through said LTCC layer (12, 14, 16) from a respective first conductor end to a second conductor end, the ground conductor members (40) of said array (50, 60) being disposed in an orientation spaced from and extending about at least part of a periphery of said electrical interconnect member (24), wherein the first and second conductor ends of the ground conductor members (40) each electrically communicate with the ground plate assembly (32, 34, 35, 36), and
the spacing of the ground conductors members (40) in the conductor array (50, 60) is selected to reduce at least one of electric and/or magnetic field interference with or from the electrical interconnect member (24).

2. The assembly as claimed in claim 1, **characterized by** a further low temperature co-fired ceramic (LTCC) layer (12), a bottom surface of said further LTCC layer (12) being positioned substantially in juxtaposition with a top surface of said LTCC layer (14), said electrical conductor (20) further comprising:
an electric conductor trace (22) extending longitudinally along said top surface,
said electric conductor trace (22) electrically communicating with said electrical conductor member (24); and
said shielding enclosure (30) further including a further array (50) of ground conductor members (40) extending transversely through each of the LTCC layers (12, 14), the ground conductor members (40) of the further array (30) being disposed along longitudinally opposed side portions of said electric conductor trace (22).

3. The assembly as claimed in claim 1 or claim 2, **characterized by** the electrical interconnect member (24) and/or each of the ground conductor members (40) have a diameter selected at between about 100 and 400 microns, and preferably about 200 microns.

4. The assembly as claimed in any one of claims 1 to 3, **characterized by** the ground conductor members (40) are spaced from said electrical interconnect member (24) by a distance selected at between about 80 and 200 microns, preferably about 100 to 150 microns, and most preferably about 125 microns.

5. The assembly as claimed in any one of claims 1 to 4, **characterized by** said assembly includes a plurality of said LTCC layers (12, 14, 16), wherein said LTCC layers are fused to each other in a stacked juxtaposed orientation.

6. The assembly as claimed in any one of claims 1 to 5, **characterized by** said LTCC layer (12, 14, 16) comprises one of a stacked pair of LTCC tape layers (12, 14, 16) having juxtaposed surfaces, said LTCC tape layers (12, 14, 16) each having a thickness selected at between about 0.1 mm and 0.9 mm;
the electrical conductor (20) comprising a metal conductor and further including metal trace conductor member (22) extending longitudinally along at least one of said juxtaposed LTCC tape layer surfaces,
the shielding enclosure (30) including a further array (60) of ground conductor members (50) extending transversely through both of said stacked LTCC tape layers (12, 14, 16), the ground conductor members (40) of said further array (50) being spaced from and oriented along longitudinal side portions of said metal trace conductor member (22).

7. The assembly as claimed in any one of claims 1 to 6, **characterized by** the electrical interconnect member is provided in electrical communication with the electrical trace conductor.

8. The assembly as claimed in any one of claims 1 to 7, **characterized by** the ground plate assembly (32, 34, 34, 36) comprises at least one ground plate extending along at least part of said LTCC layer.

9. The assembly as claimed in any one of claims 1 to 8, **characterized by** said electrical interconnect member (24) and/or said ground conductor member (40) comprise conductive metal in-filled vias.

10. The assembly as claimed in any one of claims 1 to 9, **characterized by** at least one transverse electrical conductor member (24) electrically communicating with the electrical trace conductor (22) and extending transversely through at least one of said pair of LTCC layers (12, 14, 16), said shielding enclosure (30) including a further array of ground conductors (60), the ground conductors (40) in said further array (60) extending transversely through said at least one of said pair of LTCC layers (12, 14, 16) in a partially radial spaced orientation about the transverse electrical conductor member (24).

11. The assembly of any one of claims 1 to 10, **characterized by** the ground conductor members (40) in said further conductor array (60) are provided in a generally equispaced orientation concentrically about the transverse electrical conductor member (24).

12. The assembly of any one of claims 1 to 11, **characterized by** said stacked LTCC layers (12, 14, 16) comprise fused LTCC tape layers having a thickness selected at between about 0.1 mm and 0.9 mm, and said electric conductor (20) comprise a conductive metal selected from the group consisting of gold, silver, copper and their alloys.

13. The assembly as claimed in any one of claims 1 to 12, **characterized by** the ground plate assembly (32, 34, 35, 36) includes at least one of a top ground plate extending along at least part of the top surface of the first LTCC layer (12, 14, 16), and a bottom ground plate extending along at least part of the bottom surface of the second LTCC layer (12, 14, 16).

14. A method of forming the assembly of any one of claims 1 to 13, **characterized by**:
printing an electrical trace on said part of a low temperature co-fired ceramic (LTCC) substrate to form said electrical trace conductor (20);
forming a first via array through said first LTCC substrate the vias of said first via array being spaced along longitudinally opposing side portions of said electric trace;
forming a secondary array of via holes through a second low temperature co-fired ceramic (LTCC) substrate, the second array being **characterized by** a hole spacing and orientation corresponding to a hole spacing and orientation of the first via array;
bonding said second LTCC substrate in juxtaposition with said first LTCC substrate and with the first via array aligned with the second via array;
electro depositing in each of said aligned vias conductive metal to form an associated one of said ground conductors (40) therein.

15. The method as claimed in claim 14 wherein the first via array is **characterized by** a preselected hole spacing and orientation relative to the portion of the electrical trace conductor which is selected to provide said ground conductors (40) with a spacing selected to minimize electric and/or magnetic field interference therefrom.
